(19) Europäisches Patentamt
European Patent Office
Office européen des brevets

(11) Publication number: 0 154 426 B1

(12) **EUROPEAN PATENT SPECIFICATION**

(45) Date of publication of patent specification: 13.09.89

(51) Int. Cl.$^4$: H 03 K 3/288

(21) Application number: 85300930.6

(22) Date of filing: 13.02.85

# (54) A latch circuit.

(30) Priority: 13.02.84 JP 22965/84

(43) Date of publication of application: 11.09.85 Bulletin 85/37

(45) Publication of the grant of the patent: 13.09.89 Bulletin 89/37

(84) Designated Contracting States: DE FR GB

(56) References cited:
GB-A-2 123 234

PATENT ABSTRACTS OF JAPAN, vol. 4, no. 130, 12th September 1980, page 114 E 25; & JP-A-55-83333 (TAKEDA RIKEN KOGYO K.K.) 23-06-1980

IBM TECHNICAL DISCLOSURE BULLETIN, vol. 24, no. 12, May 1982, New York, USA; D.B. EARDLEY "Latch circuit insensitive to disturb by alpha particles", pages 6461-6462

(73) Proprietor: FUJITSU LIMITED
1015, Kamikodanaka Nakahara-ku
Kawasaki-shi Kanagawa 211 (JP)

(72) Inventor: Suzuki, Hirokazu
3-17-11, Tsukimino
Yamato-shi Kanagawa 242 (JP)
Inventor: Akiyama, Takehiro
Dai-2 Shinwa-kopo 102 2271, Noborito Tama-ku
Kawasaki-shi Kanagawa 214 (JP)
Inventor: Morita, Teruo
Fujitsu Shimonoge-ryo 878 Shimonoge Takatsu-ku
Kawasaki-shi Kanagawa 213 (JP)

(74) Representative: Sunderland, James Harry et al
HASELTINE LAKE & CO Hazlitt House 28
Southampton Buildings Chancery Lane
London WC2A 1AT (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 154 426 B1

Courier Press, Leamington Spa, England.

**Description**

The present invention relates to a latch circuit used as a register, for example, between a central processing unit (CPU) and a high-speed memory in a computer system.

The latch circuit according to the present invention is advantageous against external noise, especially alpha rays from a ceramic package of an integrated circuit (IC).

As is well known, alpha rays are radiated from IC ceramic packages. When these alpha rays strike the transistors which constitute the IC, spike noise is mainly generated from the collectors of the transistors in the form of a minus (negative voltage) peak. This spike noise causes errors during logic operations of the latch circuit. Namely, when the latch circuit is maintained in a "hold mode" which has two states, i.e., a high level state and a low level state, in each of the output lines, the level which should be maintained high is changed to the low level by this spike noise, so that the changed level state is latched and is maintained.

There are, in general, two ways to deal with spike noise caused by alpha rays. First, it is possible to increase the logic amplitude between the high level and the low level in the logic operation to an extent great enough to overcome the influence of spike noise. Second, it is possible to provide a capacitor in the latch circuit in order to eliminate the spike noise by charging up the minus peak voltage.

The former technique, however, results in a lower switching speed because of the longer time taken for the change between the high level and the low level. The latter technique also results in a slower speed; in this case due to the longer time for charging and discharging of the capacitor.

Japanese unexamined Patent Application JP—A—55-83333 discloses a D-type latch circuit in which an invariably constant set up time is obtained regardless of a previous state, by connecting the collector of a transistor for receiving a clock signal, to a common emitter of the two transistors for latching data. A reference voltage $V_R$ is applied to a base of a transistor as a comparison voltage for input data, and the bases of the data-latching transistors are connected to a voltage source line via resistors.

IBM Technical Disclosure Bulletin, Vol. 24 No. 12, May 1982 p. 6461—6462, discloses a latch circuit which is rendered insensitive to disturbances by alpha particles by virtue of redundant gates added to the latch circuit. It is stated that the mechanism of disturbance by alpha particles is the negative excursion of a collector due to subcollector-substrate leakage.

According to the present invention, there is provided a latch circuit for receiving and holding write data of a predetermined logic amplitude, comprising:

a data input terminal for receiving a write data signal;

an output terminal for outputting a held data signal;

a feedback input terminal, operatively connected to said output terminal via feedback loop, for receiving a feedback signal;

a data input circuit comprising a first ECL circuit and a first clock transistor, a base terminal of said first ECL circuit being operatively connected to said data input terminal for receiving said write data signal; and

a data holding circuit comprising a second ECL circuit and a second clock transistor, said second ECL circuit being operatively connected to said first ECL circuit and said output terminal and further connected to said feedback input terminal at a base terminal thereof for holding said write data signal, said first and second clock transistors being commonly connected to a current source at the emitter terminal thereof;

characterised in that:

a reference voltage setting means is provided for said latch circuit, operable to supply a first reference voltage to another base terminal of said first ECL circuit and a second reference voltage to another base terminal of said second ECL circuit, a potential difference between a peak voltage of said logic amplitude and said second reference voltage being larger than a potential difference between said peak voltage of said logic amplitude and said first reference voltage, for reducing the susceptibility of the latch circuit to the effects of external noise.

An embodiment of the present invention can provide a latch circuit used as a register in a computer system.

An embodiment of the present invention can provide a latch circuit with reduced susceptibility to external noise, especially, alpha rays from a ceramic package of an IC circuit.

In accordance with the present invention, it is possible to reduce susceptibility to external noise, especially alpha rays from a ceramic package of an IC, thereby enabling reduction of frequency of errors in a computer system.

Reference is made, by way of example, to the accompanying drawings in which:

Fig. 1 is a basic block diagram of a latch circuit according to an embodiment of the present invention;

Fig. 2 is a circuit diagram of the latch circuit according to an embodiment of the present invention;

Fig. 3 is a timing chart of each signal of the circuit shown in Fig. 2;

Fig. 4 is a chart explaining reference voltages according to the present invention; and

Fig. 5 is a graph explaining the effect of the present invention.

In Fig. 1, a latch circuit 1 is connected between a CPU (not shown), and a high-speed memory (not shown) and used as a register for data input or data hold from or to the CPU. The latch circuit 1 basically includes three input terminals, i.e., a first input terminal C for receiving a clock pulse (CLK) generated from a clock generator (not shown), a second input terminal D for receiving write data ($D_{IN}$) transmitted from the CPU, and a third input terminal F for a feedback loop. The latch circuit 1 also includes a terminal Q for outputting the write data at a suitable timing. The feedback loop is provided between the terminal F and the terminal Q for the latch function.

Referring to Fig. 2, the latch circuit 1 proper includes an emitter-coupled logic (ECL) circuit having a series gate structure which is constituted by three current switching circuits, i.e., a set of transistors $Q_1$ and $Q_2$ of a data input section, a set of transistors $Q_3$ and $Q_4$ of a data holding section, and clock transistors $Q_5$ and $Q_6$ of the data input and holding sections respectively. Transistors $Q_7$ and $Q_8$ are used as output transistors, outputs of which are obtained from each emitter, i.e., are used as so-called emitter follower transistors. A resistor $R_a$ is connected between a common first power source $V_{cc}$ and the collector of the transistor $Q_1$, and a resistor $R_b$ is connected between the power source $V_{cc}$ and the collector of the transistor $Q_2$. Both resistors $R_a$ and $R_b$ are used as a load.

Moreover, reference numerals $I_{H1}$, $I_{H2}$, and $I_{H3}$ represent constant current sources with ends connected to a common second power source $V_{ee}$. The data input $D_{IN}$ is applied to the base of the transistor $Q_1$. When the clock pulse CLK is applied to the base of the transistor $Q_5$, the output data $D_{OUT}$ ($\bar{Q}$) is obtained from the emitter of the transistor $Q_7$ and the output data $D_{OUT}$ (Q) from the emitter of the transistor $Q_8$ as mentioned above. Two lines A and B represent an output line. One output Q is on the line A and the other inverted output $\bar{Q}$ is on the line B in this embodiment.

A circuit L indicated by the dotted line is a reference voltage setting circuit. This circuit L includes two transistors $Q_9$ and $Q_{10}$ and resistors $R_1$ to $R_5$. One reference voltage $V_{ref1}$ is obtained from the point $P_1$, the other reference voltage $V_{ref2}$ from the point $P_2$. The reference voltage $V_{ref1}$ is applied to the base of the transistor $Q_2$, and the reference voltage $V_{ref2}$ is applied to the base of the transistor $Q_3$.

The operation of these circuits will be explained in detail below.

In this circuit, there are two modes according to the levels of clock signal C and inverted clock signal $\bar{C}$, i.e., an "input mode" and "hold mode". When the clock signal C is high level and $\bar{C}$ is low level, the transistor $Q_5$ is in the ON state and the transistor $Q_6$ is in the OFF state. Therefore, the constant current $I_{H1}$ is applied to the current switching circuit $Q_1$, $Q_2$ for inputting the write data $D_{IN}$, whereas the current switching circuit $Q_3$, $Q_4$ for hold function does not work because no current is applied. In the input mode, the write data $D_{IN}$ is written in the latch circuit 1 so that each output line A(Q), B($\bar{Q}$) becomes high level or low level according to the write data $D_{IN}$. For example, when the write data $D_{IN}$ is a higher level than the reference $V_{ref1}$, the transistor $Q_1$ enters the ON state and the transistor $Q_2$ enters the OFF state, so that the output line A(Q) becomes high level and the output line B($\bar{Q}$) low level.

After the write input mode, according to the change of the clock signal C from the high level to low level and $\bar{C}$ from low to high, the transistor $Q_6$ enters the ON state and transistor $Q_5$ the OFF state, so that the current switching circuit $Q_3$, $Q_4$ becomes active due to the constant current $I_{H1}$. Consequently, since the output Q is fed back to a feedback input terminal F through the feedback loop, the input write data Q, $\bar{Q}$ (for example, Q is high and $\bar{Q}$ is low) at the output lines A, B are latched and held by the circuits $Q_3$, $Q_4$. This is the hold mode in which the current switching circuit composed of the transistors $Q_1$, $Q_2$ is not activated, so that even if the write data $D_{IN}$ is changed during the hold mode, there is no effect on the output lines A, B.

Since the output line A is fed back to the feedback input terminal F for the latch function, spike noise may be applied to the output terminal A during the hold mode. Especially, since spike noise due to alpha rays is negative noise, typically (a problem occurs when) the high level is held at the output line A and the low level is held at the output line B.

The problem caused by the alpha rays is explained in the typical situation as follows.

When alpha rays are irradiated on the circuit, spike noise N (shown in Figs. 3 and 4) producing a minus (negative) voltage peak is generated from each of the transistors. In the conventional circuit, in the hold mode in the typical situation, although the output line A must be maintained at the high level Q, the high level is changed to the low level by this spike noise, as shown by the dotted line in Fig. 3. This is because the reference voltage $V_{ref2}$ is set to the same level as the reference voltage $V_{ref1}$, at the medium level between the high level $V_{OH}$ as an upper peak voltage of a logic amplitude and the low level $V_{OL}$ as a lower peak voltage of a logic amplitude of the write data $D_{IN}$. Accordingly, when the minus peak level exceeds the $V_{ref1}$ level, i.e., falls below the threshold level of the transistor (e.g. $Q_2$), the high level $V_{OH}$ is undesirably changed to the low level (e.g. on line A). The changed low level at the output line A is fed back to the current switching circuit of the transistors $Q_3$, $Q_4$, so that the changed low level Q is latched even after the alpha ray disappears.

In this embodiment of the invention, the reference voltage $V_{ref2}$ is set to a level lower than the reference voltage $V_{ref1}$ from the high level $V_{OH}$. This reference voltage $V_{ref2}$ is also set to a level lower than the minus peak level of the noise. Accordingly, even if spike noise is generated, it does not exceed (fall below) the reference voltage $V_{ref2}$ so that the high level $V_{OH}$ is not changed to the low level $V_{OL}$, as shown in Fig. 4.

That is, the noise margin of the high level of the feedback input terminal against the reference $V_{ref2}$ is larger than that of the write data $D_{in}$ against $V_{ref1}$. As explained above, the noise margin of the write data $D_{IN}$ against $V_{ref1}$ should be determined according to the viewpoint of the logic speed. In other words, the noise margin of the write data is set to be minimum. In the present invention, the noise margin of the write data $D_{IN}$ can be the same as the conventional one, while the noise margin of the high level of the feedback input F is set larger than the conventional one by making the $V_{ref2}$ lower than $V_{ref1}$.

In the reference voltage setting circuit, both reference voltages are obtained from the following formulae.

$$V_{ref1}=R_3 \cdot I_2+V_{BEQ9}$$
$$V_{ref2}=V_{ref1}+\Delta V_{ref}$$

where,

$$\Delta V_{ref}=R_1 \cdot I_1$$

In the conventional reference voltage setting circuit, there is no resistor $R_1$ between a transistor $Q_9$ and a transistor $Q_{10}$. Accordingly, as mentioned before, the reference voltage $V_{ref1}$ is set to the same level as the reference voltage $V_{ref2}$.

In Fig. 4, reference letters $PD_1$ and $PD_2$ represent the potential difference from the high level $V_{OH}$. The potential difference $PD_1$ is equal to the difference between the high level $V_{OH}$ and the reference voltage $V_{ref1}$, and the potential difference $PD_2$ is equal to the difference between the high level $V_{OH}$ and the reference voltage $V_{ref2}$.

As an example, in Fig. 5, the ordinate represents the number of errors, i.e., failure counts (F.C) per one hour, and the abscissa represents the reference voltage level difference from the high level (here, $PD_1$ of $PD_2$). When the potential difference $PD_2$ is about 175 (mV), the failure count is about $8\times10^3$ due to the spike noise, while, when the potential difference $PD_2$ is about 200 (mV), the failure count is about $10^3$. When the potential difference $PD_2$ is about 225 (mV), the failure count is about $2\times10^2$—a considerable reduction. In this example, the logic amplitude between the high level $V_{OH}$ and the low level $V_{OL}$ is set to about 400 (mV). In general, since the minus peak level of the noise is about 180 to 200 mV, it is sufficient to set the potential difference $PD_2$, i.e., reference voltage $V_{ref2}$ level to about 225 (mV) so as to reduce error.

Further, when other external noise is added to the write data $D_{IN}$, that noise has no influence on the circuit when in the data input mode. This is because the high-level clock pulse is always applied to the base of the transistor $Q_5$ in the data input mode, so that if minus peak noise is added to the write data $D_{IN}$, the circuit can be immediately returned to the state according to the properly applied write data $D_{IN}$.

Moreover, according to the present invention, the reference voltage $V_{ref1}$ can be set to the same level as the conventional circuit for maintaining high-speed switching. This is because, if the noise margin against the reference voltage $V_{ref1}$ is set larger than the conventional level to obtain a sufficient noise margin, the switching time becomes too long and the switching speed falls to a level lower than that of a conventional circuit. Consequently, only the reference voltage $V_{ref2}$ is set lower than the reference voltage $V_{ref1}$ from the high level. Also, the output level $D_{OUT}$ of the latch circuit 1 is not changed from the conventional one so that there is no change from the external circuit to which the output $D_{OUT}$ is applied. Only the inside of the latch circuit 1 is changed, whereas the interface to the outside is not changed.

Further, as is obvious from the above explanation, when plus (positive voltage) peak noise caused by other factors than alpha rays is applied to the output line $B(\bar{Q})$ and the low level is changed to the high level in the hold mode, the reference voltage $V_{ref2}$ should be set higher than the reference voltage $V_{ref1}$ from the low level $V_{OL}$.

In the above explanation, a peak voltage of logic amplitude may be given by a high level side (high level voltage supply line). However, the peak voltage of logic amplitude may also be given by a low level side (low level voltage supply line).

## Claims

1. A latch circuit for receiving and holding write data of a predetermined logic amplitude, comprising:

a data input terminal (D) for receiving a write data signal;

an output terminal (Q) for outputting a held data signal;

a feedback input terminal (F), operatively connected to said output terminal (Q) via a feedback loop, for receiving a feedback signal;

a data input circuit comprising a first ECL circuit ($Q_1$, $Q_2$) and a first clock transistor ($Q_5$), a base terminal of said first ECL circuit being operatively connected to said data input terminal (D) for receiving said write data signal; and

a data holding circuit comprising a second ECL circuit ($Q_3$, $Q_4$) and a second clock transistor ($Q_6$), said second ECL circuit being operatively connected to said first ECL circuit and said output terminal and further connected to said feedback input terminal (F) at a base terminal thereof for holding said write data signal, said first and second clock transistors being commonly connected to a current source at the emitter terminal thereof;

characterised in that:

a reference voltage setting means (L) is provided for said latch circuit, operable to supply a first reference voltage ($V_{ref1}$) to another base terminal of said first ECL circuit ($Q_1$, $Q_2$) and a second reference voltage ($V_{ref2}$) to another base terminal of said second ECL circuit ($Q_3$, $Q_4$), a potential difference ($PD_2$) between a peak voltage ($V_{OH}$) of said logic amplitude and said second reference voltage ($V_{ref2}$) being larger than a potential difference ($PD_1$) between said peak voltage ($V_{OH}$) of said logic amplitude and said first reference voltage ($V_{ref1}$), for reducing the susceptibility of the latch circuit to the effects of external noise.

2. A latch circuit as claimed in claim 1, wherein said first ECL circuit is constituted by first and second transistors ($Q_1$ and $Q_2$) and said second

ECL circuit is constituted by third and fourth transistors ($Q_3$ and $Q_4$), said write data signal being applied to a base of said first transistor ($Q_1$), said first reference voltage ($V_{ref1}$) being applied to a base of said second transistor ($Q_2$), said second reference voltage ($V_{ref2}$) being applied to a base of said third transistor ($Q_3$) and said feedback signal being applied to a base of said fourth transistor ($Q_4$).

3. A latch circuit as claimed in claim 1 or 2, wherein said data input circuit further comprises two resistors ($R_a$ and $R_b$) used as a load, and wherein said first clock transistor ($Q_5$) is connected to receive a clock pulse (C) at its base.

4. A latch circuit as claimed in claim 1, 2 or 3, wherein said second clock transistor ($Q_6$) is connected to receive an inverted clock pulse signal ($\bar{C}$) at its base, and wherein the collectors of said third and fourth transistors ($Q_3$ and $Q_4$) are connected to the collectors of said second and first transistors ($Q_2$ and $Q_1$), respectively.

5. A latch circuit as claimed in any preceding claim, further comprising two output transistors ($Q_7$ and $Q_8$) used as emitter follower transistors.

6. A latch circuit as claimed in any preceding claim, wherein said peak voltage ($V_{OH}$) of said logic amplitude is given by a high-level side.

7. A latch circuit as claimed in any of claims 1 to 5, wherein said peak voltage of said logic amplitude is given by a low-level side.

8. A latch circuit as claimed in any preceding claim, wherein said reference voltage setting means (L) comprises ninth and tenth transistors ($Q_9$ and $Q_{10}$) and first to fifth resistors ($R_1$ to $R_5$).

9. A latch circuit as claimed in claim 8, wherein said first resistor ($R_1$) of said reference voltage setting means is connected between an emitter of said ninth transistor ($Q_9$) and a collector of said tenth transistor ($Q_{10}$), said first reference voltage ($V_{ref1}$) being obtained from a common contact point ($P_1$) of said emitter of said ninth transistor ($Q_9$) and one end of said first resistor ($R_1$), said second reference voltage ($V_{ref2}$) being obtained from a common contact point ($P_2$) of said collector of said tenth transistor ($Q_{10}$) and the other end of said first resistor ($R_1$).

**Patentansprüche**

1. Halteschaltung zum Empfangen und Halten von Schreibdaten mit einer vorbestimmten logischen Amplitude, mit:

einem Dateneingangsanschluß (D) zum Empfangen eines Schreibdatensignals;

einem Ausgangsanschluß (Q) zum Ausgeben eines gehaltenen Datensignals;

einem Rückkopplungs-Eingangsanschluß (F), der wirkungsmäßig mit dem genannten Ausgangsanschluß (Q) über eine Rückkopplungsschleige verbunden ist, um ein Rückkopplungssignal zu empfangen;

einer Dateneingangsschaltung, welche eine erste ECL-Schaltung ($Q_1$, $Q_2$) und einen ersten Takttransistor ($Q_5$) umfaßt, wobei ein Basisanschluß der genannten ersten ECL-Schaltung wirkungsmäßig mit dem genannten Dateneingangsanschluß (D) verbunden ist, um das genannte Schreibdatensignal zu empfangen; und

einer Datenhalteschaltung, die eine zweite ECL-Schaltung ($Q_3$, $Q_4$) und einen zweiten Takttransistor ($Q_6$) umfaßt, wobei die genannte zweite ECL-Schaltung wirkungsmäßig mit der genannten ersten ECL-Schaltung und dem genannten Ausgangsanschluß und ferner mit dem genannten Rückkopplungs-Eingangsanschluß (F) an ihrem einen Basisanschluß verbunden ist, um das genannte Schreibdatensignal zu halten, wobei der erste und der zweite Takttransistor mit ihrem Emitteranschluß gemeinsam mit einer Stromquelle verbunden sind;

dadurch gekennzeichnet, daß:

eine Referenzspannungs-Einstelleinrichtung (L) für die genannte Halteschaltung vorgesehen ist, die betreibbar ist, um eine erste Referenzspannung ($V_{ref1}$) an einen anderen Basisanschluß der genannten ersten ECL-Schaltung ($Q_1$, $Q_2$) und eine zweite Referenzspannung ($V_{ref2}$) an einen anderen Basisanschluß der genannten zweiten ECL-Schaltung ($Q_3$, $Q_4$) zu liefern, wobei die Potentialdifferenz ($PD_2$) zwischen der Spitzenspannung ($V_{OH}$) der genannten logischen Amplitude und der genannten zweiten Referenzspannung ($V_{ref2}$), die größer als die Potentialdifferenz ($PD_1$) zwischen der genannten Spitzenspannung ($V_{OH}$) der genannten logischen Amplitude und der genannten ersten Referenzspannung ($V_{ref1}$) ist, um die Suszeptibilität, der Verriegelungsschaltung gegenüber Effekten von äußerem Rauschen zu reduzieren.

2. Halteschaltung nach Anspruch 1, bei der die genannte erste ECL-Schaltung aus ersten und zweiten Transistoren ($Q_1$ und $Q_2$) und die genannte zweite ECL-Schaltung aus dritten und vierten Transistoren ($Q_3$ und $Q_4$) gebildet sind, das genannte Schreibdatensignal einer Basis des genannten ersten Transistors ($Q_1$) zugeführt wird, die genannte erste Spannung ($V_{ref1}$) einer Basis des genannten zweiten Transistors ($Q_2$) zugeführt wird, die genannte zweite Referenzspannung ($V_{ref2}$) einer Basis des genannten dritten Transistors ($Q_3$) zugeführt wird und das genannten Rückkopplungssignal einer Basis des genannten vierten Transistors ($Q_4$) zugeführt wird.

3. Halteschaltung nach Anspruch 1 oder 2, bei der die genannte Dateneingangsschaltung ferner zwei Widerstände ($R_a$ und $R_B$) umfaßt, die als eine Last verwendet werden, und bei der der genannte erste Takttransistor ($Q_5$) angeschlossen ist, um an seiner Basis einen Taktimpuls (C) zum empfangen.

4. Halteschaltung nach Anspruch 1, 2 oder 3, bei der der genannte zweite Takttransistor ($Q_6$) angeschlossen ist, um ein invertiertes Taktimpulssignal ($\bar{C}$) an seiner Basis zu empfangen, und bei der die Kollektoren der genannten dritten und vierten Transistoren ($Q_3$ und $Q_4$) mit den Kollektoren der genannten zweiten bzw. ersten Transistoren ($Q_2$ und $Q_1$) verbunden sind.

5. Halteschaltung nach einem der vorhergehenden Ansprüche, ferner mit zwei Ausgangstransi-

storen ($Q_7$ und $Q_8$), die als Emitterfolgertransistoren verwendet werden.

6. Halteschaltung nach einem der vorhergehenden Ansprüche, bei der die genannte Spitzenspannung ($V_{OH}$) der genannten logischen Amplitude durch eine Hochpegelseite gegeben ist.

7. Halteschaltung nach einem der Ansprüche 1 bis 5, bei der die genannte Spitzenspannung der genannten logischen Amplitude durch eine Niedrigpegelseite gegeben ist.

8. Halteschaltung nach einem der vorhergehenden Ansprüche, bei der die genannte Referenzspannungs-Einstelleinrichtung (L) neunte und zehnte Transistoren ($Q_9$ und $Q_{10}$) und erste bis fünfte Widerstände ($R_1$ bis $R_5$) umfaßt.

9. Halteschaltung nach Anspruch 8, bei der der genannte erste Widerstand ($R_1$) der genannten Referenzspannungs-Einstelleinrichtung zwischen einem Emitter des genannten neunten Transistors ($Q_9$) und einem Kollektor des genannten zehnten Transistors ($Q_{10}$) verbunden ist, die genannte erste Referenzspannung ($V_{ref1}$) von einem gemeinsamen Kontaktpunkt ($P_1$) des genannten Emitters des genannten neunten Transistors ($Q_9$) und einem Ende des genannten ersten Widerstands ($R_1$) erhalten wird, die genannte zweite Referenzspannung ($V_{ref2}$) von einem gemeinsamen Kontaktpunkt ($P_2$) des genannten Kollektors des genannten zehnten Transistors ($Q_{10}$) und des anderen Endes des genannten ersten Widerstands ($R_1$) erhalten wird.

**Revendications**

1. Circuit de verrouillage destiné à recevoir et à maintenir une donnée d'écriture d'une amplitude logique prédéterminée comprenant:

une borne d'entrée de donnée (D) servant á recevoir un signal de donnée d'écriture;

une borne de sortie (Q) servant à délivrer un signal de donnée maintenue;

une borne d'envrée de réaction (F), fonctionnellement connectée à ladite borne de sortie (Q) via une boucle de réaction, servant à recevoir un signal de réaction;

un circuit d'entrée de donnée comprenant un premier circuit ECL ($Q_1$, $Q_2$) et un premier transistor d'horloge ($Q_5$), une borne de base dudit premier circuit ECL étant fonctionnellement connecté à ladite borne d'entrée de donnée (D) afin de recevoir ledit signal de donnée d'écriture; et

un circuit de maintien de donnée comprenant un deuxième circuit ECL ($Q_3$, $Q_4$) et un deuxième transistor d'horloge ($Q_6$), ledit deuxième circuit ECL étant fonctionnellement connecté audit premier circuit ECL et à ladite borne de sortie et étant en outre connectée à ladite borne d'entrée de réaction (F) par une borne de base de manière à maintenir ledit signal de donnée d'écriture, lesdits premier et deuxième transistors d'horloge étant connectés en commun à une source de courant par leurs bornes d'émetteur;

caractérisé en ce que:

un moyen (L) de positionnement de tension de référence est prévu pour ledit circuit de verrouillage, et a pour fonction de fournir une première tension de référence ($V_{ref1}$) à une autre base dudit premier circuit ECL ($Q_1$, $Q_2$) et une deuxième tension de référence ($V_{ref2}$) à une autre borne de base dudit deuxième circuit ECL ($Q_3$ $Q_4$), la différence de potentiel ($PD_2$) entre la tension de crête ($V_{OH}$) de ladite amplitude logique et ladite deuxième tension de référence ($V_{ref2}$) étant supérieure à la difference de potentiel ($PD_1$) entre ladite tension de crête ($V_{OH}$) de ladite amplitude logique et ladite première tension de référence ($V_{ref1}$), de manière à réduire la sensibilité du circuit de verrouillage vis-à-vis des effets du bruit externe.

2. Circuit de verrouillage selon la revendication 1, où ledit premier circuit ECL est constitué par des premier et deuxième transistors ($Q_1$ et $Q_2$) et le deuxième circuit ECL est constitué par des troisième et quatrième transistors ($Q_3$ et $Q_4$), ledit signal de donnée d'écriture étant appliqué à une base dudit premier transistor ($Q_1$), ladite première tension de référence ($V_{ref1}$) étant appliquée à une base dudit deuxième transistor ($Q_2$), ladite deuxième tension de référence ($V_{ref2}$) étant appliquée à une base dudit troisième transistor ($Q_3$) et ledit signal de réaction étant appliqué à une base dudit quatrième transistor ($Q_4$).

3. Circuit de verrouillage selon la revendication 1 ou 2, où ledit circuit d'entrée de donnée comprend en outre deux résistances ($R_a$ et $R_b$) utilisées comme charge, et où ledit premier transistor d'horloge ($Q_5$) est connectée de façon à recevoir une impulsion d'horloge (C) sur sa base.

4. Circuit de verrouillage selon la revendication 1, 2 ou 3, où ledit deuxième transistor d'horloge ($Q_6$) est connectée de façon à recevoir un signal d'impulsion d'horloge inversé ($\overline{C}$) sur sa base, et où les collecteurs desdits troisième et quatrième transistors ($Q_3$ et $Q_4$) sont respectivement connectés aux collecteurs desdits deuxième et premier transistors ($Q_2$ et $Q_1$).

5. Circuit de verrouillage selon l'une quelconque des revendications précédentes, comprenant en outre deux transistors de sortie ($Q_7$ et $Q_8$) utilisés comme transistors à émetteur suiveur.

6. Circuit de verrouillage selon l'une quelconque des revendications précédentes, où ladite tension de crête ($V_{OH}$) de ladite amplitude logique est donnée par le côté du niveau haut.

7. Circuit de verrouillage selon l'une quelconque des revendications 1 à 5, où ladite tension de crête de ladite amplitude logique est donnée par le côté du niveau bas.

8. Circuit de verrouillage selon l'une quelconque des revendications précédentes, où ledit moyen (L) de positionnement de tension de référence comprend des neuvième et dixième transistors ($Q_9$ et $Q_{10}$) et des première à cinquième résistances ($R_1$ à $R_5$).

9. Circuit de verrouillage selon la revendication 8, où ladite première résistance ($R_1$) dudit moyen de positionnement de tension de référence est connectée entre un émetteur dudit neuvième transistor ($Q_9$) et un collecteur dudit dixième transistor ($Q_{10}$), ladite première tension de référence ($V_{ref1}$) étant obtenue depuis le point de contact de commun ($P_1$) dudit émetteur dudit neuvième transistor ($Q_9$) et d'une première extrémité de ladite première résistance ($R_1$), ladite deuxième tension de référence ($V_{ref2}$) étant obtenu depuis le point de contact commun ($P_2$) dudit collecteur dudit dixième transistor ($Q_{10}$) et de l'autre extrémité de ladite première résistance ($R_1$).

Fig. 1

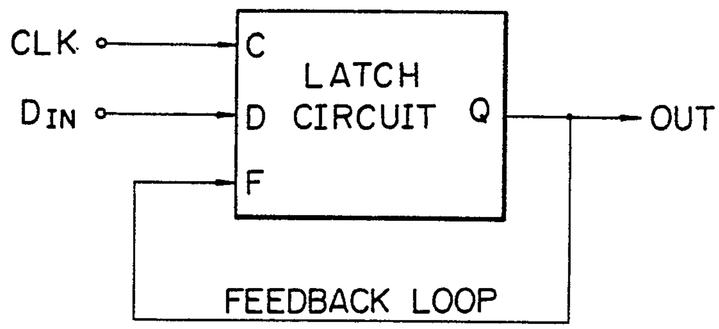
CLK
DIN
C
LATCH
CIRCUIT
D
Q
F
OUT
FEEDBACK LOOP

Fig. 5

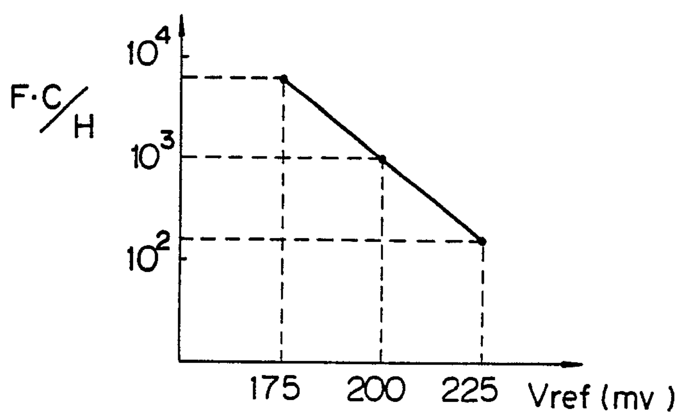
F·C/H
10^4
10^3
10^2
175
200
225
Vref (mv )

Fig. 2

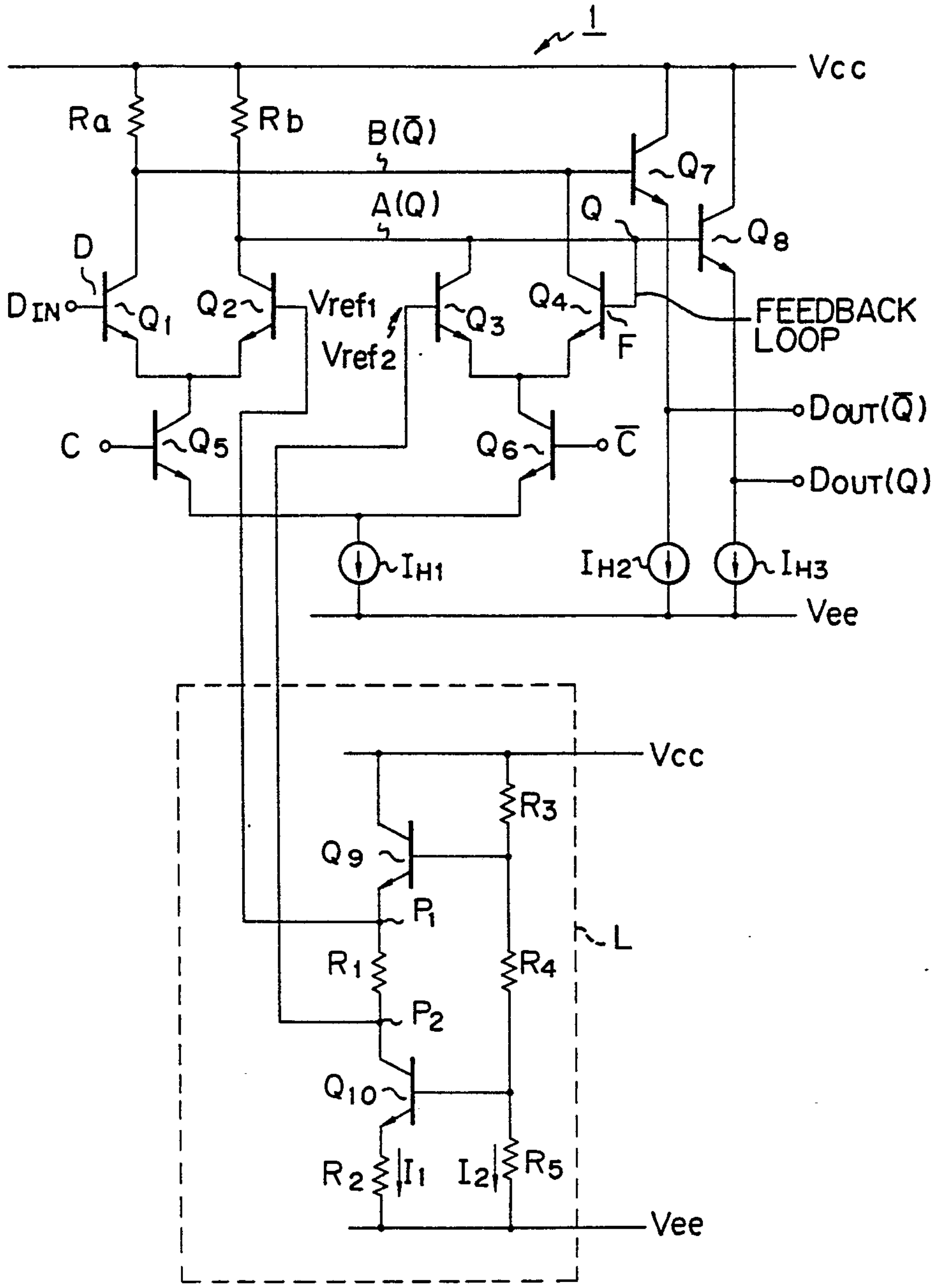
1
Vcc
Ra
Rb
B(Q̄)
Q7
A(Q)
Q
Q8
D
DIN
Q1
Q2
Vref1
Q3
Q4
FEEDBACK
LOOP
Vref2
F
DOUT(Q̄)
C
Q5
Q6
C̄
DOUT(Q)
IH1
IH2
IH3
Vee
Vcc
R3
Q9
P1
L
R1
R4
P2
Q10
R2
I1
I2
R5
Vee

Fig. 3

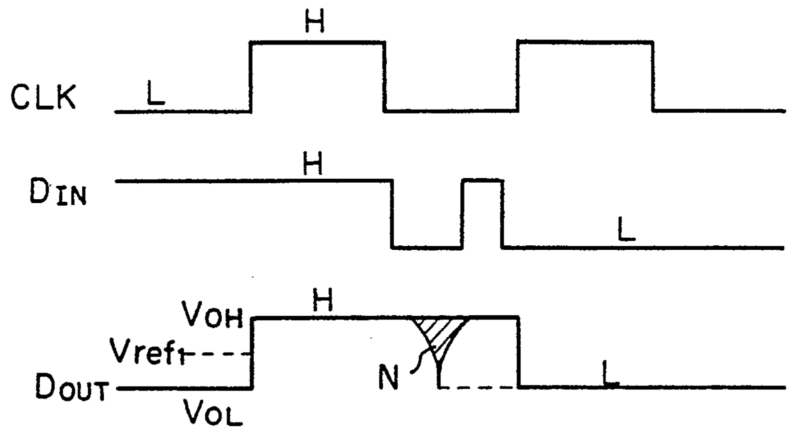
H
CLK
L
H
DIN
L
VOH
H
Vref1
N
DOUT
VOL
L

Fig. 4

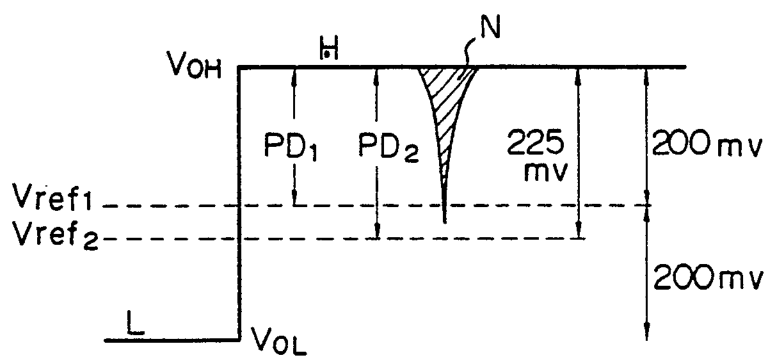
N
VOH
H
PD1
PD2
225 mv
200mv
Vref1
Vref2
200mv
L
VOL